# EUROPEAN PATENT SPECIFICATION

(11) **EP 1 758 208 B1**
(45) Date of publication and mention of the grant of the patent: **12.03.2008**
(21) Application number: 06017087.5
(22) Date of filing: 16.08.2006
(51) Int. Cl.: H01R 12/18

(54) **A connector and a mounting method therefor**
Verbinder und Motageverfahren
Connecteur et procédé de montage

(30) Priority: 22.08.2005 JP 2005240159
(43) Date of publication of application: 28.02.2007
(73) Proprietor: Sumitomo Wiring Systems, Ltd., Yokkaichi-City, Mie, 510-8503 (JP)
(72) Inventor: Nakano, Hiroshi, Yokkaichi-city, Mie 510-8503 (JP)
(74) Representative: Müller-Boré & Partner Patentanwälte

(56) References cited:
- US-A- 5 270 492
- US-B1- 6 287 130
- PATENT ABSTRACTS OF JAPAN vol. 013, no. 176, 25 April 1989 (1989-04-25) & JP 01 006385 A (CANON), 10 January 1989 (1989-01-10)

## Description

The present invention relates to connector for an electric or electronic device, in particular to a circuit board connector, and to a method of mounting or assembling it to or on an electric or electronic device, in particular to a circuit board.

A general construction of a connector to be mounted on a circuit board by reflow soldering is known from Japanese Unexamined Patent Publication No. 2003-17164. L-shaped fixing members are provided at the opposite sides of this connector, and are soldered to the circuit board to be fixed at the time of reflow soldering.

If bubbles are created between the circuit board and fixing members upon performing reflow soldering, fixing strength to the circuit board is reduced. As a countermeasure, a method can be thought according to which through holes are formed in the fixing members and bubble are let to escape through these holes. However, if the through holes are formed, a bonding area to the circuit board is reduced, resulting in reduced bonding strength to the circuit board.

The present invention was developed in view of the above problem, and an object thereof is to restrain a reduction in bonding strength to a circuit board while suppressing or reducing the production of bubbles.

This object is solved according to the invention by the features of the independent claims. Preferred embodiments are subject of the dependent claims.

According to the invention, there is provided a connector for an electric or electronic device such as a circuit board in which a connector housing is provided with at least one fixing member to be fixed to the electric or electronic device such as the circuit board, the fixing member has at least one bonding portion to be bonded to solder, and the bonding portion is formed with at least one through hole, wherein:
the bonding portion is provided with such a connecting piece as to at least partly cover the through hole at a surface substantially opposite to a connecting surface with the solder, and
the connecting piece can be bonded to the solder while defining at least one clearance for letting bubbles created in the solder at least partly escape between the connecting piece and the bonding portion such that the clearance substantially communicates with the through hole.

According to a preferred embodiment of the invention, the fixing member is to be fixed to the electric or electronic device such as the circuit board by reflow soldering.

Accordingly, a reduction in bonding strength to the circuit board can be restrained since the connecting piece is so provided as to be able to be bonded to the solder while defining the clearance for letting bubbles created in the solder escape.

According to a preferred embodiment of the invention, there is further provided a circuit board connector in which a connector housing is provided with a fixing member to be fixed to a circuit board by reflow soldering, the fixing member has a bonding portion to be bonded to solder, and the bonding portion is formed with a through hole, wherein:
the bonding portion is provided with such a connecting piece as to cover the through hole at a surface opposite to a connecting surface with the solder, and
the connecting piece can be bonded to the solder while defining a clearance for letting bubbles created in the solder escape between the connecting piece and the bonding portion such that the clearance communicates with the through hole.

Accordingly, a reduction in bonding strength to the circuit board can be restrained since the connecting piece is so provided as to be able to be bonded to the solder while defining the clearance for letting bubbles created in the solder escape.

Preferably, the connecting piece is formed by cutting a part of the bonding portion and bending the cut part.

Accordingly, since the connecting piece is formed by cutting and bending the part of the bonding portion, it can be more easily formed as compared to a case where a connecting piece is separately prepared and attached to the bonding portion later.

Further preferably, the connecting piece is formed by forming a substantially gate-shaped slit whose opening side is faced toward a mounting portion of the fixing member.

Still further preferably, the bonding portion is formed with one or more slits at one or more positions spaced apart in width direction, thereby being divided into two or more projecting pieces.

Further preferably, each projecting piece is to be soldered to the electric or electronic device.

Yet further preferably, one or more mounting surfaces are provided in or on the housing so as to be brought into sliding contact with respective one or more mounting portions of the fixing member.

Most preferably, the mounting surfaces are recessed inward preferably substantially by the width of the bonding portions, so that the opposite widthwise side surfaces of the connector housing and the widthwise outer edges of the bonding portions are substantially flush with each other with the fixing members at least partly mounted in the mounting portions.

According to the invention, there is further provided a method of mounting a connector to an electric or electronic device such as a circuit board, in particular according to the invention or a preferred embodiment thereof, comprising the following steps:
providing a connector housing with at least one fixing member to be fixed to the electric or electronic device such as the circuit board, the fixing member has at least one bonding portion to be bonded to solder, and the bonding portion is formed with at least one through hole, wherein:
   providing a connecting piece at the bonding portion so as to at least partly cover the through hole at a surface substantially opposite to a connecting surface with the solder, and
   bonding the connecting piece to the solder while defining at least one clearance for letting bubbles created in the solder at least partly escape between the connecting piece and the bonding portion such that the clearance substantially communicates with the through hole.

According to a preferred embodiment of the invention, the fixing member is fixed to the electric or electronic device by reflow soldering.

These and other objects, features and advantages of the present invention will become more apparent upon reading of the following detailed description of preferred embodiments and accompanying drawings. It should be understood that even though embodiments are separately described, single features thereof may be combined to additional embodiments.
FIG. 1 is a perspective view of a connector according to a first embodiment,
FIG. 2 is a plan view of the connector,
FIG. 3 is a front view of the connector, and
FIG. 4 is a section showing a state where solder is bonded to the lower surface of a connecting piece in a bonding portion.

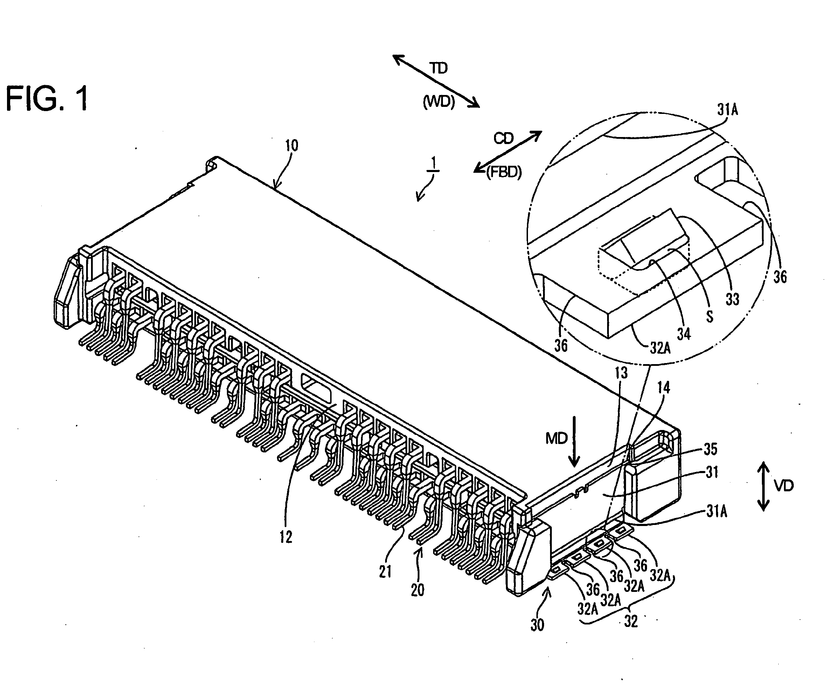

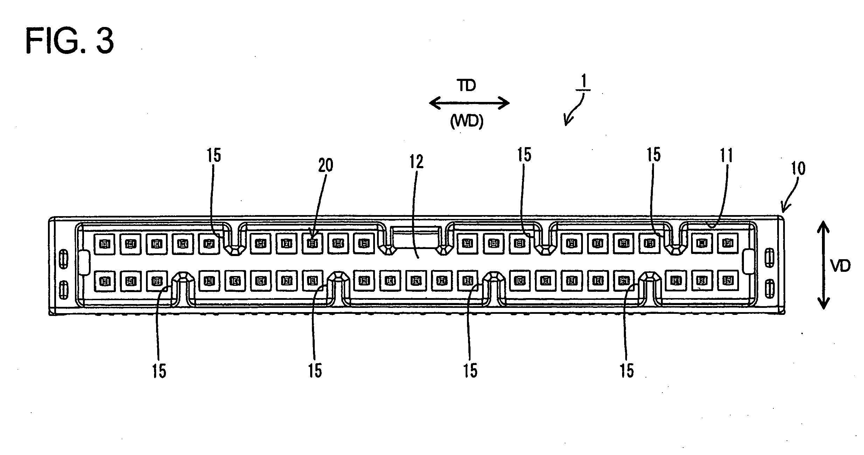

One preferred embodiment of the present invention is described with reference to FIGS. 1 to 4. A connector 1 for an electric or electronic device such as a circuit board B according to this embodiment is provided with a connector housing 10, one or more male terminals 20 and one or more fixing members 30 as shown in FIG. 1 or 3. In the following description, reference is made to a connecting direction CD concerning forward and backward directions FBD, a side to be connected being a front side; to a transverse direction TD in FIG. 3 concerning a width direction WD; and to a vertical direction in FIG. 3 concerning a vertical direction VD, an upper side as shown in FIG. 3 being referred to an upper side.

The connector housing 10 is made e.g. of a synthetic resin and has a receptacle 11 having an open front side as shown in FIG. 1 or 3. An unillustrated female connector is at least partly fittable or insertable into the receptacle 11 substantially along the connecting direction CD. Further, as shown in FIG. 3, one or more guiding protrusions 15 are formed at one or more (e.g. seven) positions arranged substantially along forward and backward directions FBD. The guiding protrusions 15 are engaged with one or more respective (unillustrated) guiding recesses formed in the female connector, thereby preventing an erroneous connection of the two connectors along vertical direction VD and/or guiding a connecting operation.

One or more (preferably substantially tab-shaped) male terminals 20 penetrate a back wall 12 of the receptacle 11 substantially in forward and backward directions FBD. One or more, preferably a plurality of male terminals 20 made of a conductive material such as a metal are arranged preferably substantially in width direction WD at one or more stages, preferably at two (upper and lower) stages at or on the back wall 12 of the receptacle 11. One side of each male terminal 20 at least partly projects substantially forward in the receptacle 11, and the other side thereof preferably has the width thereof narrowed as compared to the one side and is pulled out backward from the back wall 12 of the receptacle 11. After projecting backward from the back wall 12 of the receptacle 11, the other side of the male terminal 20 is oriented at an angle different from 0° or 180°, preferably substantially normal or downward toward the electric or electronic component such as the printed circuit board B and is bent again at an angle different from 0° or 180°, preferably substantially normal to preferably extend substantially backward at least partly on the electric or electronic component such as a circuit board B, thereby forming a connecting portion 21 with the electric or electronic component such as the circuit board B. The connecting portions 21 are arranged preferably on a substantially straight line at the substantially same intervals in width direction WD on the circuit board B. On the circuit board B, an unillustrated land is formed at a position corresponding to the connecting portions 21, and this/these land(s) is/are to be fixed to the connecting portions 21 preferably by applying unillustrated solder to this land. Thus, the connecting portions 21 are electrically connected with the land on the circuit board B preferably by reflow soldering.

As shown in FIG. 1, the one or more fixing members 30 for fixing the connector 1 to the circuit board B preferably by reflow soldering are mounted on the (preferably substantially opposite) side surface(s) of the connector housing 10 with respect to width direction WD. Each fixing member 30 is formed of a flat conductive (preferably metal) plate into a bent shape, preferably substantially an L-shape, and includes a mounting portion 31 to be mounted on the connector housing 10 and a bonding portion 32 to be connected or bonded to the electric or electronic component such as the printed circuit board B, preferably to be soldered thereto. The (preferably substantially opposite) surface(s) of the connector housing 10 with respect to width direction WD to substantially face the respective mounting portion(s) 31 serve(s) as one or more mounting surfaces 13 that can be brought into sliding contact with the mounting portions 31. Specifically, as shown in FIG. 1, one or more bulging portions 35 are formed to bulge out preferably substantially forward and/or backward from the (preferably substantially opposite) lateral edge(s) of each mounting portion 31 with respect to forward and backward directions FBD. On the other hand, one or more slits 14 are formed along vertical direction VD at positions of the connector housing 10 substantially corresponding to the one or more bulging portions 35. The bulging portions 35 are at least partly insertable into the slits 14 from a mounting direction MD, preferably substantially from above, and the bottom end positions of the slits 14 are set such that any further movement in the mounting direction MD (preferably substantially downward movement) of the fixing member 30 is prevented when the bonding portion 32 reaches the outer surface of the circuit board B. In this way, the fixing member 30 is temporarily held in the connector housing 10.

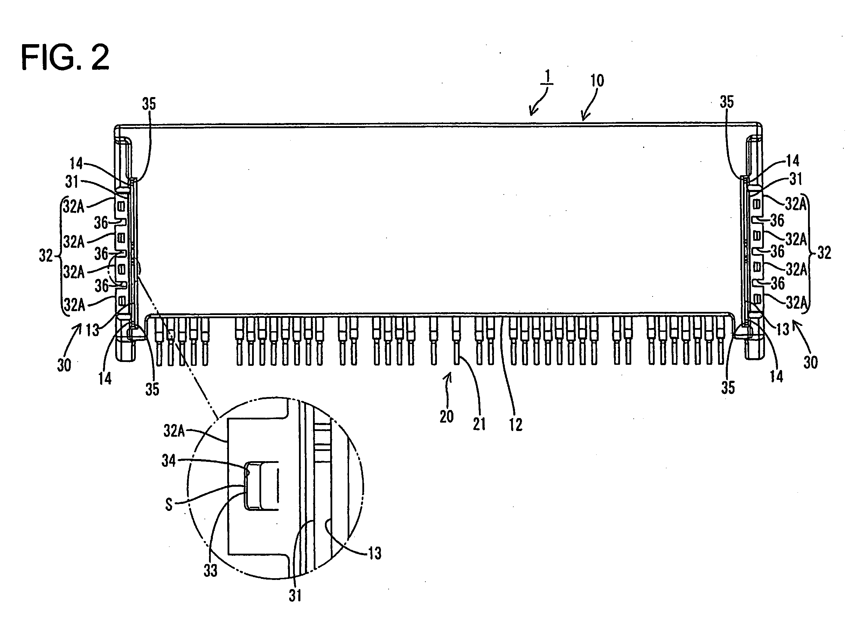

As shown in FIG. 2, the mounting surfaces 13 are recessed inward preferably substantially by the width of the bonding portions 32, so that the opposite widthwise side surfaces of the connector housing 10 and the widthwise outer edges of the bonding portions 32 are substantially flush with each other with the fixing members 30 at least partly mounted in the mounting portions 31. On the circuit board B, unillustrated mounting portions (copper foils) are formed at positions substantially corresponding to the bonding portions 32, and preferably unillustrated solder is applied to these mounting portions. Thus, the bonding portions 32 are fixed while preferably being soldered to the mounting portions on the circuit board B more preferably by reflow soldering.

As shown in FIG. 1, at least one stepped portion 31 A is formed to project substantially outward (or at an angle different from 0° or 180°, preferably substantially normal) at the bottom end of the mounting portion 31 by a dimension that is preferably about half the thickness of the mounting portion 31. In the case where the circuit board connector 1 is installed in a place having a high temperature atmosphere, even if the mounting portions 31 of the fixing members 30 are pushed by the connector housing 10 due to a difference in thermal expansion between the connector housing 10 and the circuit board B, pressing forces are taken up while the mounting portions 31 are resiliently deformed with the one or more stepped portions 31A as supporting points, thereby preventing or significantly reducing the transmission of the pressing forces to the bonding portions 32. As a result, the one or more bonding portions 32 are kept fixed to the circuit board B without creating shear forces between the bonding portions 32 and the circuit board B, whereby a detachment of the connector housing 10 from the circuit board B is prevented.

As shown in FIG. 1, each bonding portion 32 is formed with one or more slits 36 at one or more (e.g. three) positions spaced apart in width direction WD, thereby being divided into two or more (e.g. four) projecting pieces 32A. The slits 36 extend from the projecting edge of the bonding portion 32 to positions at least more than half the extension in width direction WD of the bonding portion 32, preferably to positions near the boundary to the stepped portion 31A. In the case where such a force as to turn the bonding portion 32 up acts in forward or backward direction, even if a part of the bonding portion 32 is turned up, the remaining part is kept secured to the circuit board B since the force is divided at the respective positions of the slits 36. As a result, a detachment of the connector housing 10 from the circuit board B can be prevented.

In an intermediate position (preferably substantially in the center) of each projecting piece 32A is formed a connecting piece 33 preferably by forming a substantially gate-shaped slit whose opening side is faced toward the mounting portion 31 and bending a portion at least partly surrounded by this slit upward. A clearance S is defined between the bottom edge of the leading end of the connecting piece 33 and the wall of a through hole 34 to be described later. Although the connecting pieces 33 preferably are bent at such an angle that the bottom edges of the leading ends thereof are located substantially above the upper surface of the bonding portion 32 in this embodiment, the bottom edges of the leading ends of the connecting pieces 33 may be located below the upper surface of the bonding portion 32.

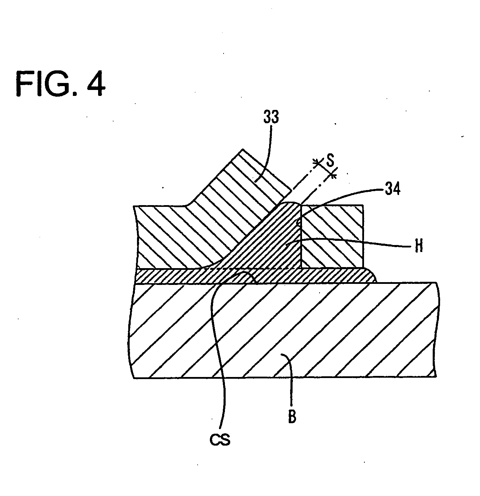

The one or more clearances S substantially communicate with the one or more respective through holes 34 formed by bending the connecting pieces 33. Thus, bubbles created in solder e.g. at the time of reflow soldering can be let to at least partly escape to the outside through the clearances S. Further, spaces into which molten solder H at least partly enter e.g. at the time of reflow soldering are formed between the lower surfaces of the connecting pieces 33 and the inner surfaces of the through holes 34 in the bonding portion 32 as shown in FIG. 4. Accordingly, the bonding portion 32 is provided with such a connecting piece 33 as to at least partly cover the through hole 34 at a surface substantially opposite or corresponding to a connecting surface CS with the solder H on the circuit board B. Accordingly, the lower surfaces of the connecting pieces 33 and the inner surfaces of the through holes 34 can be soldered, whereby effective bonding strength can be maintained without reducing a bonding area to a circuit board B to a large extent.

Next, functions of this embodiment constructed as above are described.

First, the connector 1 is at least partly placed and positioned on the electric or electronic device such as the circuit board B such that the one or more connecting portions 21 of the one or more male terminals 20 are located on the unillustrated land on the circuit board B and the one or more bonding portions 32 of the one or more fixing members 30 are located on the unillustrated mounting portions on the circuit board B. Subsequently, the circuit board B having the connector 1 placed thereon preferably is passed through an unillustrated reflow furnace. Then, the solder H is molten in the reflow furnace, and bubbles may be created in the molten solder H at the lower surfaces of the bonding portions 32 in some cases. However, the bubbles created in the solder H can be let to escape to the outside through the one or more clearances S communicating with the one or more through holes 34. Further, the molten solder H at least partly enters the through holes 34 in the reflow furnace, whereby the lower surfaces of the connecting pieces 33 and the inner surfaces of the through holes 34 are soldered as shown in FIG. 4. There is no likelihood of decreasing the bonding area to the circuit board B to reduce bonding strength by providing the through holes 34 for letting the bubbles escape. Therefore, the bonding strength to the circuit board B is not reduced while enabling the bubbles created in the solder H to escape to the outside.

As described above, a reduction in the bonding strength to the circuit board B can be restrained or reduced since, in this embodiment, the one or more connecting pieces 33 to be bonded to the solder H are provided while defining the one or more clearances S for letting the bubbles created in the solder H at least partly escape. Further, since the connecting pieces 33 preferably are provided by cutting and bending the parts of the bonding portion 32, they can be more easily provided as compared to a case where the connecting pieces 33 are separately prepared and attached to the bonding portions 32 later.

Accordingly, to enable a reduction in bonding strength to an electric or electronic device such as a circuit board B to be restrained while letting bubbles created in solder escape, a connector 1 for an electric or electronic device such as a printed circuit board B is provided with a connector housing 10, one or more male terminals 20 and one or more fixing members 30. Each fixing member 30 is formed by bending a (preferably metal) flat plate into a bent shape, preferably substantially an L-shape, and comprised of a mounting portion 31 used to mount the fixing member 30 into the connector housing 10, and a bonding portion 32 to be connected, preferably soldered. The bonding portion 32 is formed with one or more connecting pieces 33 preferably by making substantially "gate"-shaped cuts in the bonding portion 32 to penetrate the bonding portion 32 and then bending parts enclosed by these cuts upward or in a direction away from the circuit board B. A clearance S is defined between the bottom edge of the leading end of each connecting piece 33 and the hole wall of a corresponding through hole 34 substantially facing this bottom edge (connecting surface CS of the circuit board B). The one or more clearances S substantially communicate with the one or more through holes 34 formed upon bending the one or more connecting pieces 33. The lower surfaces of the connecting pieces 33 and the inner surfaces of the through holes 34 can be soldered.

### <Other Embodiments>

The present invention is not limited to the above described and illustrated embodiment. For example, the following embodiments are also embraced by the technical scope of the present invention as defined by the claims. Beside the following embodiments, various changes can be made without departing from the scope of the present invention as defined by the claims.
(1) Although the connecting pieces supported at one side are formed by cutting and bending the parts of the bonding portions in the foregoing embodiment, another mode may be adopted provided that the one or more clearances S substantially communicating with the one or more through holes are defined. A connecting piece supported at both sides may be formed by forming two parallel slits and striking a part between the slits to project substantially upward from below the bonding portion.
(2) As still another mode, an edge section of each bonding portion may be folded up by 180° to at least partly cover the through holes from above.
(3) As further another mode, separate connecting pieces may be prepared and attached to the bonding portions later.
(4) Although the fixing members are attached to the connector housing later in the foregoing embodiment, they may be formed integrally or unitarily with the connector housing preferably by insert molding according to the present invention.
(5) Although each bonding portion is formed with the one or more slits to be divided into two or more (e.g. four) projecting pieces in the foregoing embodiment, it may not be necessarily divided and may be in the form of a single plate.
(6) The present invention is also applicable to connectors to be fixed to electric or electronic devices other than printed circuit boards such as junction boxes, dashboard panels, fuse boxes, relais boxes or the like.

### LIST OF REFERENCE NUMERALS

- 1: connector
- 10: connector housing
- 11: receptacle
- 12: back wall
- 30: fixing member
- 31: mounting portion
- 32: bonding portion
- 33: connecting piece
- 34: through hole
- B: circuit board
- H: solder
- S: clearance

## Claims

1. A connector for an electric or electronic device such as a circuit board (B) in which a connector housing (10) is provided with at least one fixing member (30) to be fixed to the electric or electronic device such as the circuit board (B), the fixing member (30) has at least one bonding portion (32) to be bonded to solder (H), and the bonding portion (32) is formed with at least one through hole (34), **characterized in that**
the bonding portion (32) is provided with such a connecting piece (33) as to at least partly cover the through hole (34) at a surface substantially opposite to a connecting surface (CS) with the solder (H), and
the connecting piece (33) can be bonded to the solder (H) while defining at least one clearance (S) for letting bubbles created in the solder (H) at least partly escape between the connecting piece (33) and the bonding portion such that the clearance (S) substantially communicates with the through hole (34).

2. A connector according to claim 1, wherein the fixing member (30) is to be fixed to the electric or electronic device such as the circuit board (B) by reflow soldering.

3. A connector according to one or more of the preceding claims, wherein the connecting piece (33) is formed by cutting a part of the bonding portion (32) and bending the cut part.

4. A connector according to one or more of the preceding claims, wherein the connecting piece (33) is formed by forming a substantially gate-shaped slit whose opening side is faced toward a mounting portion (31) of the fixing member (30).

5. A connector according to one or more of the preceding claims, wherein the bonding portion (32) is formed with one or more slits (36) at one or more positions spaced apart in width direction (WD), thereby being divided into two or more projecting pieces (32A).

6. A connector according to claim 5, wherein each projecting piece (32A) is to be soldered to the electric or electronic device (B).

7. A connector according to one or more of the preceding claims, wherein one or more mounting surfaces (13) are provided in or on the housing (10) so as to be brought into sliding contact with respective one or more mounting portions (31) of the fixing member (30).

8. A connector according to claim 7, wherein the mounting surfaces (13) are recessed inward preferably substantially by the width of the bonding portions (32), so that the opposite widthwise side surfaces of the connector housing (10) and the widthwise outer edges of the bonding portions (32) are substantially flush with each other with the fixing members (30) at least partly mounted in the mounting portions (31).

9. A method of mounting a connector to an electric or electronic device such as a circuit board (B), comprising the following steps:
providing a connector housing (10) with at least one fixing member (30) to be fixed to the electric or electronic device such as the circuit board (B), the fixing member (30) has at least one bonding portion (32) to be bonded to solder (H), and the bonding portion (32) is formed with at least one through hole (34), **characterized by**
providing a connecting piece (33) at the bonding portion (32) so as to at least partly cover the through hole (34) at a surface substantially opposite to a connecting surface (CS) with the solder (H), and
bonding the connecting piece (33) to the solder (H) while defining at least one clearance (S) for letting bubbles created in the solder (H) at least partly escape between the connecting piece (33) and the bonding portion such that the clearance (S) substantially communicates with the through hole (34).

10. A method according to claim 9, wherein the fixing member (30) is fixed to the electric or electronic device (B) by reflow soldering.

## Patentansprüche

1. Verbinder für eine elektrische oder elektronische Vorrichtung, wie beispielsweise eine Leiterplatte (B), in welchem ein Verbindergehäuse (10) mit wenigstens einem festlegenden bzw. Befestigungsglied (30) versehen ist, um an der elektrischen oder elektronischen Vorrichtung, wie beispielsweise der Leiterplatte (B), fixiert bzw. festgelegt zu sein bzw. zu werden, das festlegende Glied (30) wenigstens einen Bondingabschnitt (32) aufweist, welcher an ein Lot (H) zu bonden ist, und der bondende bzw. Bondingabschnitt (32) mit wenigstens einem Durchtrittsloch (34) ausgebildet ist, **dadurch gekennzeichnet, daß**
der bondende Abschnitt (32) mit einem derartigen verbindenden bzw. Verbindungsstück (33) versehen ist, um wenigstens teilweise das Durchtrittsloch (34) an einer Fläche bzw. Oberfläche im wesentlichen gegenüberliegend bzw. entgegengesetzt zu einer verbindenden bzw. Verbindungsfläche bzw. -oberfläche (CS) mit dem Lot (H) abzudecken, und
das verbindende Stück (33) an das Lot (H) gebondet werden kann, während wenigstens ein Freiraum (S) definiert ist, um Blasen, welche in dem Lot (H) erzeugt sind bzw. werden, wenigstens teilweise zwischen dem verbindenden Stück (33) und dem bondenden Abschnitt entweichen zu lassen, so daß der Freiraum bzw. Abstand (S) im wesentlichen mit dem Durchtrittsloch (34) kommuniziert bzw. in Verbindung steht.

2. Verbinder nach Anspruch 1, wobei das festlegende Glied (30) an der elektrischen oder elektronischen Vorrichtung, wie beispielsweise der Leiterplatte (B), durch ein Reflow- bzw. Aufschmelzlöten festzulegen bzw. zu befestigen ist.

3. Verbinder nach einem oder mehreren der vorangehenden Ansprüche, wobei das verbindende Stück (33) durch ein Schneiden eines Teils des bondenden Abschnitts (32) und ein Biegen des geschnittenen Teils ausgebildet ist bzw. wird.

4. Verbinder nach einem oder mehreren der vorangehenden Ansprüche, wobei das verbindende Stück (33) durch ein Ausbilden eines im wesentlichen tor- bzw. gliedförmigen Schlitzes ausgebildet ist, dessen Öffnungsseite in Richtung zu einem Montageabschnitt (31) des festlegenden Glieds (30) gerichtet ist.

5. Verbinder nach einem oder mehreren der vorangehenden Ansprüche, wobei der bondende Abschnitt (32) mit einem oder mehreren Schlitz(en) (36) an einer oder mehreren Position(en) ausgebildet ist, welche voneinander in einer Breitenrichtung (WD) beabstandet sind, wodurch er in zwei oder mehrere vorragende Stücke (32A) unterteilt ist bzw. wird.

6. Verbinder nach Anspruch 5, wobei jedes vorragende Stück (32A) an die elektrische oder elektronische Vorrichtung (B) zu löten ist.

7. Verbinder nach einem oder mehreren der vorangehenden Ansprüche, wobei eine oder mehrere Montagefläche(n) bzw. -oberfläche(n)(13) in oder an dem Gehäuse (10) vorgesehen ist bzw. sind, um in gleitenden Kontakt mit einem entsprechenden oder mehreren Montageabschnitt(en) (31) des festlegenden Glieds (30) gebracht zu werden.

8. Verbinder nach Anspruch 7, wobei die Montageflächen bzw. -oberflächen (13) nach innen vorzugsweise im wesentlichen durch die Breite der bondenden Abschnitte (32) vertieft bzw. abgesetzt sind, so daß die gegenüberliegenden bzw. entgegengesetzten Seitenflächen bzw. -oberflächen in Breitenrichtung des Verbindergehäuses (10) und die äußeren Ränder bzw. Kanten in Breitenrichtung der bondenden Abschnitte (32) im wesentlichen bündig miteinander sind, wobei die festlegenden Glieder (30) wenigstens teilweise in den Montageabschnitten (31) montiert bzw. angeordnet sind.

9. Verfahren zum Montieren eines Verbinders an einer elektrischen oder elektronischen Vorrichtung, wie beispielsweise einer Leiterplatte (B), umfassend die folgenden Schritte:
Versehen eines Verbindergehäuses (10) mit wenigstens einem festlegenden bzw. Befestigungsglied (30), um an der elektrischen oder elektronischen Vorrichtung, wie beispielsweise der Leiterplatte (B), festgelegt bzw. befestigt zu werden, wobei das festlegende Glied (30) wenigstens einen bondenden bzw. Bondingabschnitt (32) aufweist, welcher an Lot (H) zu bonden ist, und der bondende Abschnitt (32) mit wenigstens einem Durchtrittsloch (34) ausgebildet wird, **gekennzeichnet durch** ein
Bereitstellen eines verbindenden bzw. Verbindungsstücks (33) an dem bondenden Abschnitt (32), um wenigstens teilweise das Durchtrittsloch (34) an einer Oberfläche im wesentlichen gegenüberliegend bzw. entgegengesetzt zu einer verbindenden bzw. Verbindungsfläche bzw. -oberfläche (CS) mit dem Lot (H) abzudecken, und
Bonden des verbindenden Stücks (33) an das Lot (H), während wenigstens ein Zwischen- bzw. Freiraum (S) definiert wird, um Blasen, welche in dem Lot (H) erzeugt werden, wenigstens teilweise zwischen dem verbindenden Stück (33) und dem bondenden Abschnitt austreten zu lassen, so daß der Freiraum (S) im wesentlichen mit dem Durchtrittsloch (34) kommuniziert bzw. in Verbindung steht.

10. Verfahren nach Anspruch 9, wobei das festlegende Glied (30) an der elektrischen oder elektronischen Vorrichtung (B) durch ein Reflow-Löten bzw. Aufschmelzlöten festgelegt bzw. befestigt wird.

## Revendications

1. Connecteur pour un dispositif électrique ou électronique tel qu'une carte de circuit (B), dans lequel un boîtier de connecteur (10) comporte au moins un élément de fixation (30) à fixer au dispositif électrique ou électronique tel que la carte de circuit (B), l'élément de fixation (30) comporte au moins une partie de liaison (32) à lier à une matière de soudage (H), et la partie de liaison (32) comporte au moins un trou de traversée (34),
**caractérisé en ce que**
la partie de liaison (32) comporte une pièce de connexion (33) de façon à couvrir au moins en partie le trou de traversée (34) à l'endroit d'une surface sensiblement opposée à une surface de connexion (CS), avec la matière de soudage (H), et
la pièce de connexion (33) peut être liée à la matière de soudage (H) tout en définissant au moins un jeu (S) pour laisser les bulles engendrées dans la matière de soudage (H) s'échapper au moins partiellement entre la pièce de connexion (33) et la partie de liaison de sorte que le jeu (S) communique sensiblement avec le trou de traversée (34).

2. Connecteur selon la revendication 1, dans lequel l'élément de fixation (30) doit être fixé au dispositif électrique ou électronique, tel que la carte de circuit (B), par soudage à reflux.

3. Connecteur selon une ou plusieurs des revendications précédentes, dans lequel la pièce de connexion (33) est formée par coupe d'une portion de la partie de liaison (32) et pliage de la portion coupée.

4. Connecteur selon une ou plusieurs des revendications précédentes, dans lequel la pièce de connexion (33) est formée par exécution d'une fente sensiblement en forme de porte dont le côté d'ouverture est tourné vers une partie de montage (31) de l'élément de fixation (30).

5. Connecteur selon une ou plusieurs des revendications précédentes, dans lequel la partie de liaison (32) comporte une ou plusieurs fentes (36) à une ou plusieurs positions mutuellement espacées dans la direction de largeur (WD), de sorte qu'elle est divisée en deux pièces en saillie (32A) ou plus.

6. Connecteur selon la revendication 5, dans lequel chaque pièce en saillie (32A) doit être soudée au dispositif électrique ou électronique (B).

7. Connecteur selon une ou plusieurs des revendications précédentes, dans lequel une ou plusieurs surfaces de montage (13) sont prévues dans ou sur le boîtier (10) de façon à être amenées en contact glissant avec une ou plusieurs parties de montage respectives (31) de l'élément de fixation (30).

8. Connecteur selon la revendication 7, dans lequel les surfaces de montage (13) sont évidées vers l'intérieur de préférence sensiblement de la largeur des parties de liaison (32), de sorte que les surfaces latérales opposées dans le sens de la largeur du boîtier de connecteur (10) et les bords extérieurs dans le sens de la largeur des parties de liaison (32) sont sensiblement en affleurement mutuel, avec les éléments de fixation (30) au moins partiellement montés dans les parties de montage (31).

9. Procédé de montage d'un connecteur sur un dispositif électrique ou électronique tel qu'une carte de circuit (B), comprenant les étapes suivantes :
préparation d'un boîtier de connecteur (10) ayant au moins un élément de fixation (30) à fixer au dispositif électrique ou électronique tel que la carte de circuit (B), l'élément de fixation (30) présente au moins une partie de liaison (32) à lier à la matière de soudage (H), et la partie de liaison (32) est formée avec au moins un trou de traversée (34),:
**caractérisé par**
la préparation d'une pièce de connexion (33) à l'endroit de la partie de liaison (32) de façon à couvrir au moins partiellement le trou de traversée (34) à l'endroit d'une surface sensiblement opposée à une surface de connexion (CS) avec la matière de soudage (H), et
la liaison de la pièce de connexion (33) à la matière de soudage (H) tout en définissant au moins un jeu (S) pour laisser les bulles, engendrées dans la matière de soudage (H), s'échapper au moins partiellement entre la pièce de connexion (33) et la partie de liaison de sorte que le jeu (S) communique substantiellement avec le trou de traversée (34).

10. Procédé selon la revendication 9, dans lequel l'élément de fixation (30) est fixé au dispositif électrique ou électronique (B) par soudage à reflux.
